# EUROPEAN PATENT APPLICATION

(11) **EP 1 893 009 A2**
(43) Date of publication of application: **27.02.2008**
(21) Application number: 07016163.3
(22) Date of filing: 17.08.2007
(51) Int. Cl.: H05K 7/18, H05K 5/00

(54) **Constructive lay-outs applied in telecommunications cabinets**

(30) Priority: 25.08.2006 BR MU8601764
(71) Applicant: Nilko Metalurgia, Ltda., 83325-360 Pinhais PR (BR)
(72) Inventor: Huscher, Fraimundo, Curitiba PR (BR)
(74) Representative: Lorente Berges, Ana

(57) **Abstract**

The present patent describes, in the technical field of telecommunications cabinets in general, a cabinet (1) for telecommunications that in accordance to its general characteristics has, as basic principle, the manufacturing of modular cabinets, either standardized or personalized, of easy installation and assembly. The cabinet is made of a structure of extruded profiles (4), which allows a series of combinations of shapes and sizes, besides having a system of sliding fittings for the closing panels (16).

## Description

The current utility model patent refers to specific telecommunications cabinets in general, and more specifically, to the constructive lay-outs applied in a telecommunications cabinet which, in accordance to its general characteristics, has as basic principle the manufacturing of modular cabinets, either standardized or customized, of easy assembly and installation, built on a structure of extruded profiles that allows for several combinations of shapes and sizes, besides providing a system of slipping fits for the closing panels which allow for more security, better use of space, better finishing and quick assembly. With a modem and specific design allowing easy access for better fitting and security, practical characteristics for assembly and functionality, accessible costs and, due to its general characteristics and dimensions, being easily adaptable to any kind of telecommunications equipment cabinets of any size, independently of what pieces of equipment are inside it and how they are installed.

The patent in consideration has as main trait to join components and processes in a differentiated conception that will fulfil the many requirements that the nature of the utilization requires, i.e. the optimization of the manufacturing and assembling of the cabinets, keeping the same level of protection for the telecommunications equipment when facing the most diverse working conditions. That conception guarantees a cabinet for the protection of telecommunications equipment of great efficiency, functionality, strength, durability, versatility and safety due to the excellence of the aggregated technical qualities that provides advantages and improvements to this kind of cabinets as a whole, which also have general characteristics unlike the ones of the other shapes and models known by the existing technical state of the art.

The cabinets widely known by the technical state of the art and currently used in telecommunications, are usually built with welded structures and bolted profiles, with the welded structures acting as a limiter in terms of shapes and models and also being of difficult assembly; as for the case of the structures built with bolted profiles, they consist of ducts for floating nuts in all the fastening sides, something that holds good results for the manufacturing of modular cabinets, but presents considerable difficulties when assembling the cabinets, since too much time is required to localize and assemble the pairs of nuts and bolts, the reason for that being that the nuts are almost always hidden behind an angle steel or a profile, and when trying to fix a bolt to most of them, they usually move away from position, requiring the assembler to reposition them time and again until he is able to fix them, therefore consuming considerable time in assembling the cabinets; another detail worth of consideration is the installation of the closing panels that are fitted from outside the cabinet with the help of screws, and which, whenever a fix is needed, require the removal of all screws, besides presenting a potential fragility when facing the action the of ill intended individuals.

The constructive lay-outs applied in a telecommunications cabinet are based in a product with a differentiated and innovative conception, which allows the solution of some of the main problems and inconveniences shown by the other shapes and models known by the existing technical state of the art, and that can be employed in the assembly, finishing and security of telecommunications cabinets; the cabinet being the object of the current patent is produced based on a structure of extruded profiles built on aluminium or a similar material, that keeps the ducts for the floating nuts only on the sides where the hinges are installed since those remain loose until the final adjustment of the doors; for the other sides or profiles which does not require a hinge, a system with ducts and longitudinal threads is used, allowing for the direct fastening of the screws on the profile, thus discarding the need of floating nuts and therefore solving one of the current problems of the technical state of the art, since this process allows the assembler to fix the bolt in any place without having to worry about adjusting the nut to a previously determined place, and therefore making the process to assembly the cabinets simpler and less time consuming; another improvement are the profiles themselves, which besides the longitudinal threads, also have a system of flanges that allow the sliding and fastening of the closing panels without having to bolt them; therefore, the profiles with flanges aggregate practicality, security and a good finishing, thus allowing for a simple and fast maintenance. Besides these advantages, the profiles have been perfectly elaborated in several models which allow a series of different combinations and fastening of boards and internal devices, as well as the development of cabinets of different models and sizes.

The present patent employs modem, versatile, efficient and functional improvements introduced in the development of telecommunications cabinets, comprising a set of mechanical solutions correctly incorporated establishing a set of profiles and devices that greatly facilitate and reduce the time to assembly, as well as the final finishing, all that in addition to great strength and security, exclusive design, detailed superb finishing, aesthetic attractiveness and with exclusive characteristics, resulting in a totally efficient and economical cabinet, built in aluminium or similar materials, and basically consisting of: a metallic rectangular base, a constructive lay-out in the column profiles with mixed fastening elements and flange, a constructive lay-out in the column profiles with fastening elements and double flange as a fitting element for the closing panels, a constructive lay-out in the cross bracing profiles as an element of locking, mechanical lift and finishing, a constructive lay-out applied to the top cover, a constructive lay-out for the hinges, a constructive lay-out applied in the framing profiles used for the doors and fake covers, a constructive lay-out applied in the composition of the plates used in the doors, fake covers, and closing panels as security elements, as a mean to make feasible in the body of the general telecommunications equipment cabinet made of double aluminium plates or similar material and with a closing system of the sandwich type, plate to plate, double wall and extenders, of a complete and totally secure ensemble, which the internal and external shapes allow for the perfect storage inside it of the most diverse types of telecommunications equipment, with the specific goal of creating guarantee and protection for its integrity, and for the integrity of the equipment stored inside it, when facing situations of undesirable access attempts and the action of bad weather conditions, when installed in public places, or similar ones.

Through the present improvements introduced in the telecommunications equipment storing cabinet, is possible to increase productivity, reduce costs with materials and manpower, diversify models and sizes, protect the equipment against vandalism or theft, and improve the strength of the ensemble against bad weather or similar conditions, incorporating state of the art technological solutions which provide an excellent level of security, strength, durability and quality to the whole process of protection and utilization of these cabinets to store telecommunications equipment.

The objectives, advantages, and other important characteristics of the considered patent, will be better understood when jointly read with the drawings in annex, where:

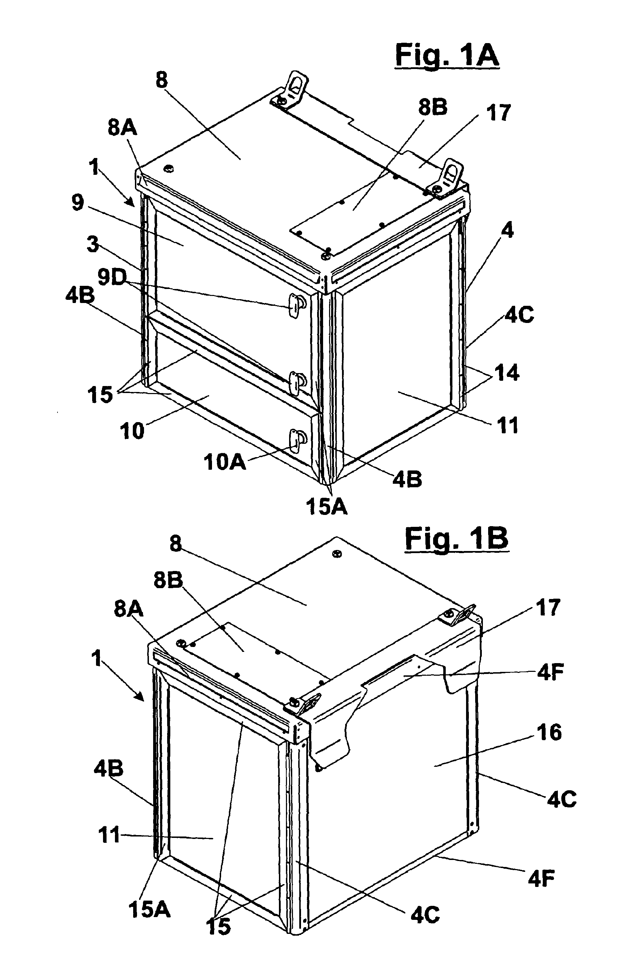

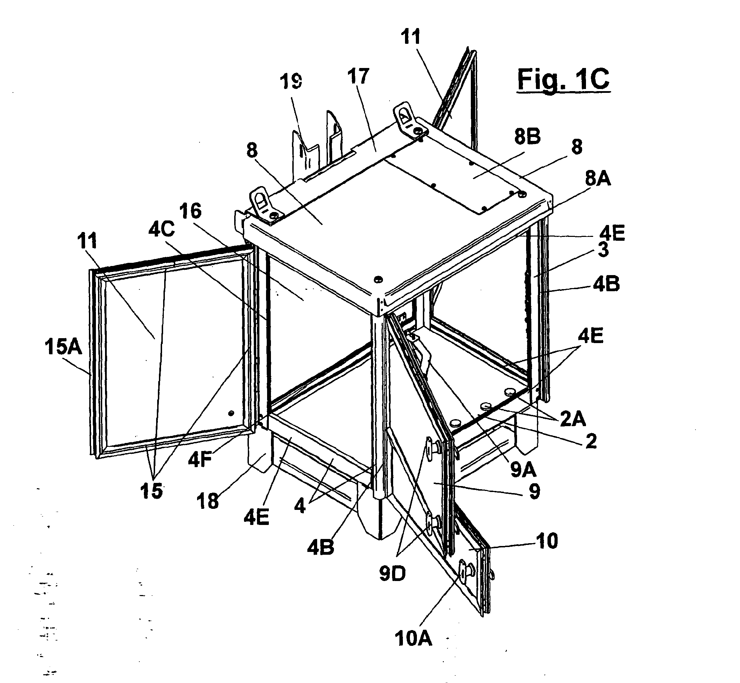

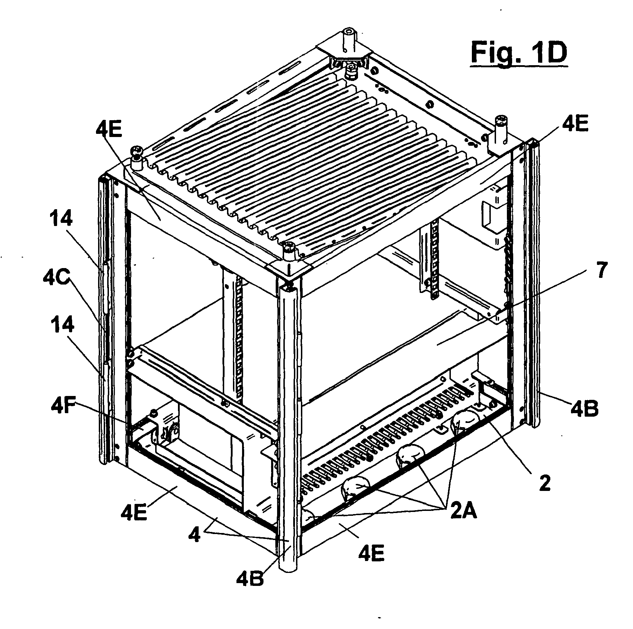

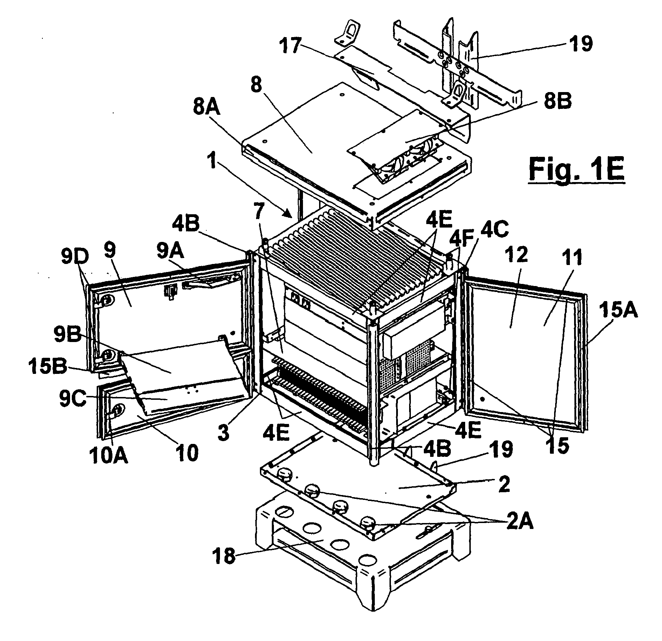

Figure 1A shows a front view of the constructive lay-outs applied in a telecommunications cabinet.
Figure 1B shows a back view of the constructive lay-outs applied in a telecommunications cabinet.
Figure 1C shows a perspective view of the constructive lay-outs applied in a telecommunications cabinet.
Figure 1D shows an exploded perspective view of the constructive lay-outs applied in a telecommunications cabinet in the disposition with some internal accessories.
Figure 1E shows an exploded perspective view of the constructive lay-outs applied in a telecommunications cabinet in the disposition with internal and external accessories.

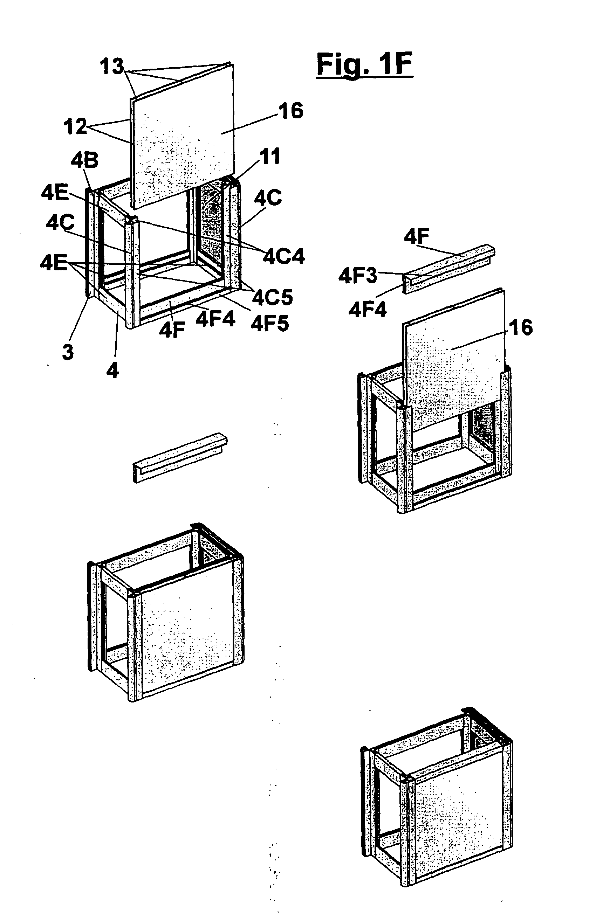

Figure 1F shows a schematic draw of the sequence to fit the backside closing panel to the cabinet profiles.
Figure 1G shows a topside view of a schematic drawing of the assembly of the constructive lay-outs applied in a telecommunications cabinet.

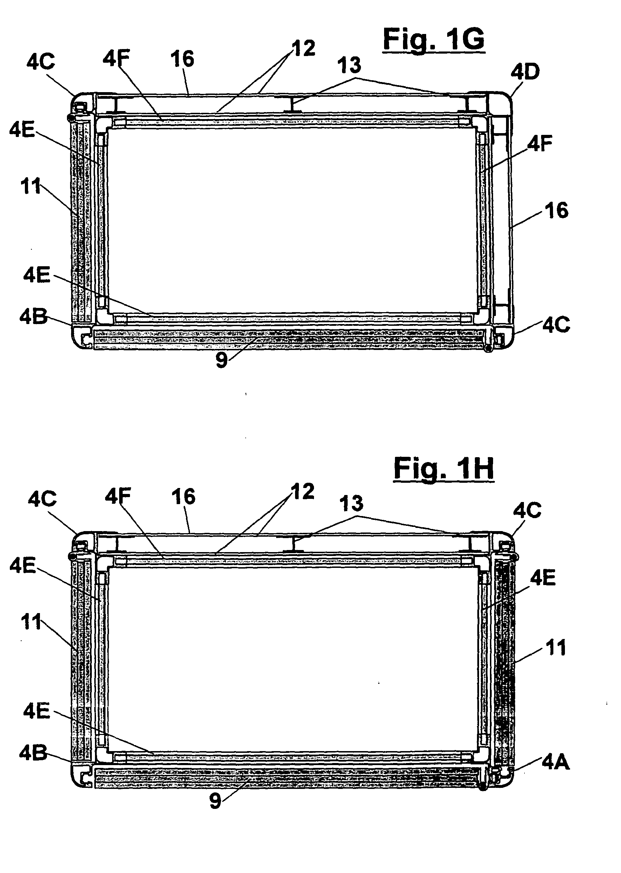

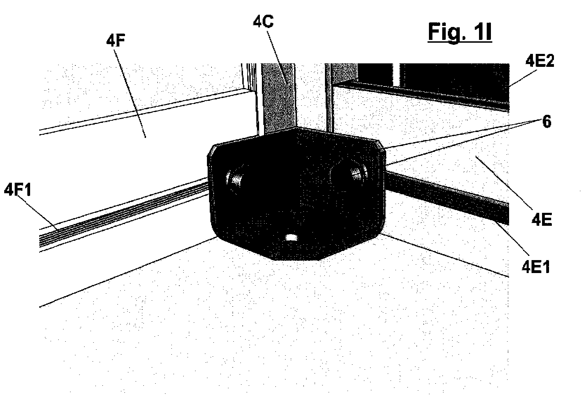

Figure 1H shows a topside view of a schematic drawing of the assembly of the constructive lay-outs applied in a telecommunications cabinet.
Figure 1I shows a perspective view of a detail of the constructive lay-outs applied in a telecommunications cabinet.

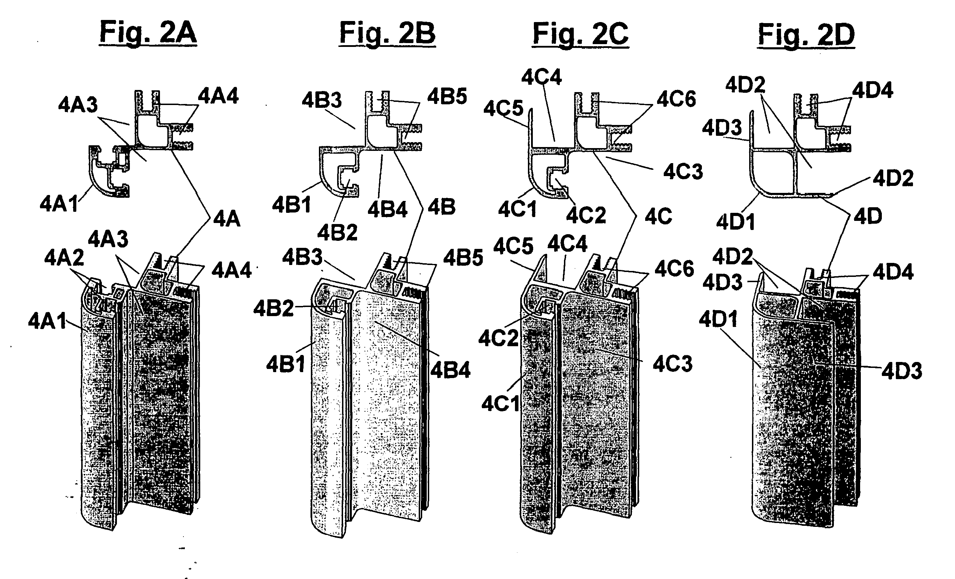

Figure 2A shows a topside and in perspective view of the column profile in the double duct disposition.
Figure 2B shows a topside and in perspective view of the column profile in the duct and door support disposition.
Figure 2C shows a topside and in perspective view of the backside column profile in the duct and flange disposition.
Figure 2D shows a topside and in perspective view of the backside column profile in the double flange disposition.

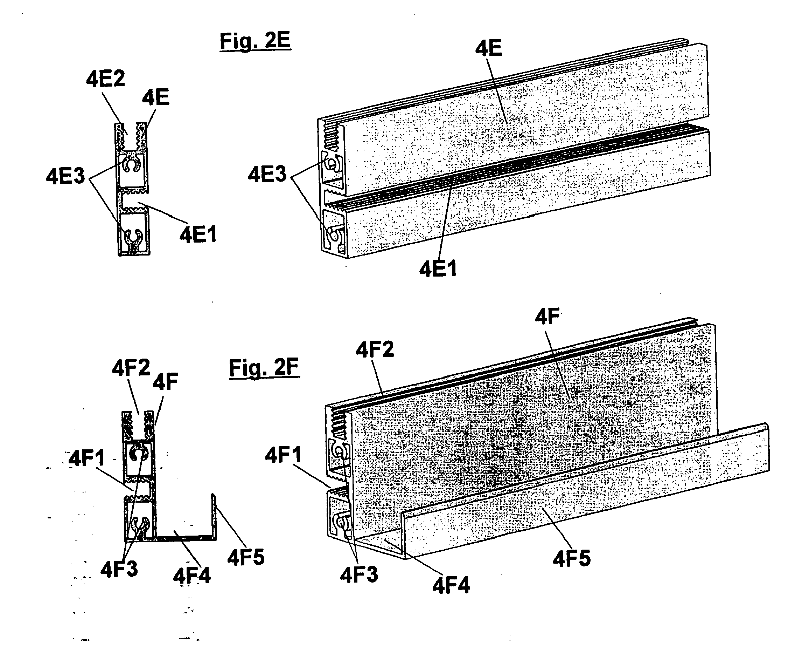

Figure 2E shows a frontal and in perspective view of the cross bracing profile.
Figure 2F shows a frontal and in perspective view of the cross bracing with flange profile.

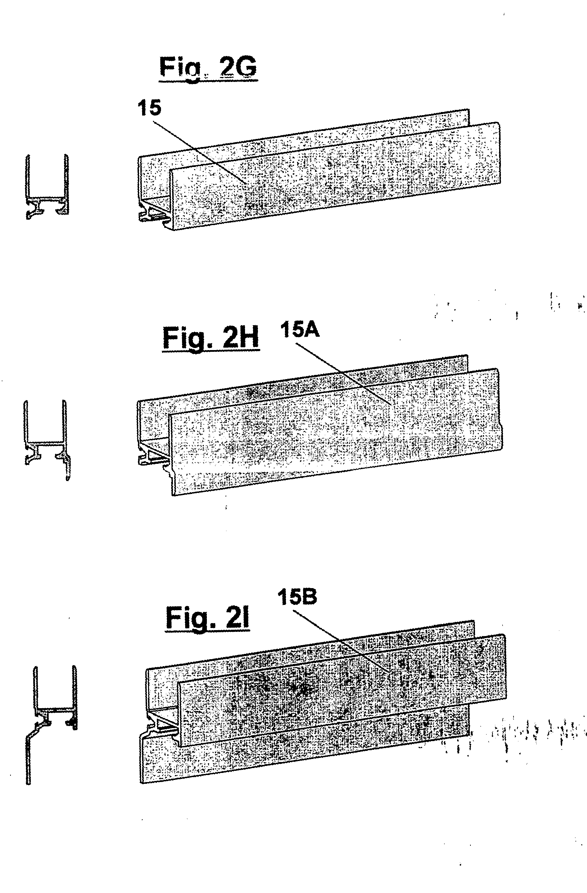

Figure 2G shows a frontal and in perspective view of the frame profile.
Figure 2H shows a frontal and in perspective view of the frame with external flange profile.
Figure 2I shows a frontal and in perspective view of the frame with internal flange profile.

As can be inferred from the drawings in annex, which are part of this descriptive report on the utility model of the patent of the "Constructive Lay-outs Applied in a Telecommunications Cabinet", in the figures in annex the dispositions are presented in a general way, compounded by an ensemble of devices and improvements for the composition of modular cabinets, either standardized or personalized, being of easy installation and assembly, built with metallic materials or similar ones, with shape and disposition, both internal and external, in a way that allows a perfect storage of the most diverse types of telecommunications equipments in general inside the cabinet (1), which in turn comprises a base (2) made of a metallic structure in a rectangular shape with entries for conduits (2A), over which it is built with a set of extruded profiles (4) made of aluminium and formed by the column profiles (4A), (4B), (4C), and (4D) and by the cross bracing profiles (4E) and (4F), each one of them with a system of longitudinal threads (5) distributed through the internal walls of the profiles' ducts, which in turn are used for the direct fastening of the bolts (6); on the internal side of the framework (3), dividing plates (7) of general specific shapes, are fastened to serve as a base for the fastening of wires, cables and electronic components; the cabinet (1) has in its upper side a cover (8) in a shape of a parallelepiped, with openings and lateral flanges (8A) and an upper opening (8B) with a general rectangular shape; for the closing of the sides of the cabinet (1), there are on its the front an upper door (9) that has a door limiter (9A), a tray (9B) with an expander (9C) and locks (9D), and a little bit lower another door (10) is located, with lock (10A); for the sides' moveable covers (11), a general rectangular shape is used, being those as well as the doors (9) and (10), made of double aluminium plates (12) or similar material, and fastened in a sandwich plate-to-plate way, with general "T" shape extenders (13), both with hinges (14); and for closing the cabinet sides, frame profiles (15), frame profiles with external flanges (15A) and frame profiles with internal flanges (15B) are used; in the upper side of the cabinet (1) a closing panel in the general shape of a rectangle and also made of double plates (12) and with extenders, (13)is positioned, fitted and fastened to the ducts (4C2) present in the profiles (4C); finally, for the cabinet's (1) fastening, two supports are used - one inferior and the other superior - both allowing attachment to a pole (19).

The column profiles (4A) of a specific general shape have an arched border (4A1) to allow for the corner's finishing, two ducts (4A2) arranged in opposing sides that are used for the sliding and fitting of the floating nuts (A), two perpendicular bases (4A3) arranged in opposing sides and used for fitting the doors (9) and (10) or the moveable covers (11); two ducts (4A4) where the threads (5) are placed; the column profiles (4A) are vertically arranged in the frontal corners of the framework (3).

The column profiles (4B) of a specific general shape have an arched border (4B1) to allow for the corner's finishing, one duct (4B2) used for the sliding and fitting of the floating nuts (A), two perpendicular bases (4B3) and (4B4) arranged in opposing sides and used for fitting the doors (9) and (10) or the moveable covers (11); two ducts (4B5) where the threads (5) are placed; the column profiles (4B) are vertically arranged in the frontal corners of the framework (3).

The column profiles (4C) of a specific general shape have an arched border (4C1) to allow for the corner's finishing, one duct (4C2) used for the sliding and fitting of the floating nuts (A), one perpendicular base (4C3) used for fitting the doors (9) and (10) or the moveable covers (11); one duct (4C5) used for the sliding and fastening of the closing panel (16), a flange (4C5) used for external finishing, two ducts (4C6) where the threads (5) are placed; the column profiles (4C) are vertically arranged in the front or the backside corners of the framework (3).

The column profiles (4D) of a specific general shape have an arched border (4D1) to allow for the corner's finishing, two ducts (4D2) that are used for the sliding and fastening of the closing panels (16), with flanges (4D3) used for external finishing purposes and two ducts (4D4) where the threads (5) are placed; the column profiles (4C) are vertically arranged in the front or the backside corners of the framework (3).

The cross bracing profiles (4E) of a general parallelepiped shape and made of straight lines, have a frontal duct (4E1) with threads (5), an upper duct (4E2) also with threads (5), semi-circular ducts (4E3) located in the internal side of the profile; being the profile horizontally arranged and serving as support and locking for the base (2) and the column profiles.

The cross bracing profiles (4F) of a general "L" shape and made of straight lines, have a backside duct (4F1) with threads (5), an upper duct (4F2) also with threads (5), semi-circular ducts (4F3) located in the internal side of the profile, one duct (4F4) for downmost support and upper closing of the closing panel (16) and a frontal flange (4F5) for finishing purposes; the profile (4F) is horizontally arranged, serving as support and locking for both, the base (2) and the column profiles, as well as support, locking and finishing element for the closing panel (16).

The structures (3) can be built with the most diverse combination of profiles (4), while keeping their remaining characteristics.

The constructive lay-outs applied in telecommunications cabinet having all its components totally fitted and fastened, can guarantee that nothing will become loose with usage, that it is quickly assembled, that there are no parts prone to break-up or bending, and that it has a long durability and it's absolutely safe. After fitted and fastened to the cabinet's body (1), the components remain locked and tied, thus precluding any component to become loose with usage, and keeping the ensemble totally available for storing any kind of telecommunications equipment. Therefore, the cabinet (1) can be easily and directly used with no concerns whatsoever in relation to its durability and security.

Having its structures built from metallic material, or a similar material of the same or greater strength and lightness, the improvements introduced in the cabinets for storing telecommunications equipment and, consequently, their components and accessories, do not rust, are waterproof, possess great durability and strength, offer improved security and, when generally applied to the cabinets (1), do not present any risks related to the stress of its structures or of the stored equipment.

Based on what has been exposed, one can say that these cabinets will be very well received by the companies that manufacture and use cabinets for the storage of telecommunications equipment in general, since the constructive lay-outs applied in a telecommunications cabinet present many advantages, such as: great security, reliability and nimbleness in its applications and use, since it involves high technology concepts; great strength and general durability allied to a small or even non-existent wearing of the ensemble as a whole; improved comfort, convenience and security for the users; highly accessible costs allowing for an optimum cost / benefit ratio; can be easily and safely used by any kind of user; maintenance interventions easy to perform and at a low cost; great mobility and flexibility of the ensemble, being easy to transport to any place; modem and bold design; installation and assembly practical and safe; general dispositions that doesn't hinder the normal operation of the cabinet, without any waste physical space; great strength against bad weather conditions; inner access totally controlled; more internal space available in the cabinet; and last but not least, the certainty to have a cabinet (1) capable of storing the most diverse types of telecommunications equipment that completely fulfils the basic conditions necessary to its application, the rules and legislations related to the area, and the basic requirements related to security, durability, and practicality; nevertheless, the measures, dimensions, and quantities can vary in accordance to its usage needs.

## Claims

1. "CONSTRUCTIVE LAY-OUTS APPLIED IN A TELECOMMUNICATIONS CABINET", is **characterized by** an ensemble of devices and improvements used in the composition of modular standardized or personalized cabinets, of easy installation and assembly, built with metallic materials or similar ones, of a shape and internal and external disposition that favours the storage of the most diverse types of telecommunications equipment inside the cabinet (1), comprising a base (2) made of a metallic structure in a rectangular shape with entries for conduits (2A), over which it is built with a set of extruded profiles (4) made of aluminium and formed by the column profiles (4A), (4B), (4C), and (4D) and by the cross bracing profiles (4E) and (4F), each one of them with a system of longitudinal threads (5) distributed through the internal walls of the profiles' ducts, which in turn are used for direct fastening of the bolts (6); on the internal side of the framework (3), dividing plates (7) of general specific shapes, are fastened to serve as a base for the fastening of wires, cables and electronic components; the cabinet (1) has in its upper side a cover (8) in a shape of a parallelepiped, with openings and lateral flanges (8A) and an upper opening (8B) with a general rectangular shape; for the closing of the sides of the cabinet (1), there are on the front of the cabinet an upper door (9) that has a door limiter (9A), a tray (9B) with an expander (9C) and locks (9D), and a little bit lower another door (10) is located, with lock (10A); for the sides moveable covers (11) a general rectangular shape is used, being those, as well as the doors (9) and (10), made of double aluminium plates (12) or similar material which are fastened in a sandwich plate-to-plate way, with general "T" shape extenders (13), both with hinges (14); for closing the cabinet sides, frame profiles (15), frame profiles with external flanges (15A) and frame profiles with internal flanges (15B) are used; in the upper side of the cabinet (1), a closing panel in the general shape of a rectangle and also made of double plates (12) and with extenders, (13) is positioned, fitted and fastened to the ducts (4C2) present in the profiles (4C); finally, for the cabinet's (1) fastening, two supports are used - one inferior and the other superior - both allowing attachment to a pole (19).

2. "CONSTRUCTIVE LAY-OUTS APPLIED IN A TELECOMMUNICATIONS CABINET", in accordance with the claim 1, is **characterised by** column profiles (4A) of a specific general shape that have an arched border (4A1) to allow for the corner's finishing, two ducts (4A2) arranged in opposing sides that are used for the sliding and fitting of the floating nuts (A), two perpendicular bases (4A3) arranged in opposing sides and used for fitting the doors (9) and (10) or the moveable covers (11); two ducts (4A4) where the threads (5) are placed; the column profiles (4A) are vertically arranged in the frontal corners of the framework (3).

3. "CONSTRUCTIVE LAY-OUTS APPLIED IN A TELECOMMUNICATIONS CABINET", in accordance with the claim 1, is **characterized by** column profiles (4B) of a specific general shape that have an arched border (4B1) to allow for the corner's finishing, one duct (4B2) used for the sliding and fitting of the floating nuts (A), two perpendicular bases (4B3) and (4B4) arranged in opposing sides and used for fitting the doors (9) and (10) or the moveable covers (11); two ducts (4B5) where the threads (5) are placed; the column profiles (4B) are vertically arranged in the frontal corners of the framework (3).

4. "CONSTRUCTIVE LAY-OUTS APPLIED IN A TELECOMMUNICATIONS CABINET", in accordance with the claim 1, is **characterized by** column profiles (4C) of a specific general shape that have an arched border (4C1) to allow for the corner's finishing, one duct (4C2) used for the sliding and fitting of the floating nuts (A), one perpendicular base (4C3) used for fitting the doors (9) and (10) or the moveable covers (11); one duct (4C5) used for the sliding and fastening of the closing panel (16), a flange (4C5) used for external finishing, two ducts (4C6) where the threads (5) are placed; the column profiles (4C) are vertically arranged in the front or the backside corners of the framework (3).

5. "CONSTRUCTIVE LAY-OUTS APPLIED IN A TELECOMMUNICATIONS CABINET", in accordance with the claim 1, is **characterized by** column profiles (4D) of a specific general shape that have an arched border (4D1) to allow for the corner's finishing, two ducts (4D2) that are used for the sliding and fastening of the closing panels (16), with flanges (4D3) used for external finishing purposes and two ducts (4D4) where the threads (5) are placed; the column profiles (4C) are vertically arranged in the front or the backside corners of the framework (3).

6. "CONSTRUCTIVE LAY-OUTS APPLIED IN A TELECOMMUNICATIONS CABINET", in accordance with the claim 1, is **characterized by** cross bracing profiles (4E) of a general parallelepiped shape and made of straight lines, which have a frontal duct (4E1) with threads (5), an upper duct (4E2) also with threads (5), semi-circular ducts (4E3) located in the internal side of the profile; being the profile horizontally arranged and serving as support and locking, both for the base (2) and the column profiles

7. "CONSTRUCTIVE LAY-OUTS APPLIED IN A TELECOMMUNICATIONS CABINET", in accordance with the claim 1, is **characterized by** cross bracing profiles (4F) of a general "L" shape and made of straight lines, which have a backside duct (4F1) with threads (5), an upper duct (4F2) also with threads (5), semi-circular ducts (4F3) located in the internal side of the profile, one duct (4F4) for downmost support and upper closing of the closing panel (16) and a frontal flange (4F5) for finishing purposes; the profile (4F) is horizontally arranged, serving as support and locking, both for the base (2) and the column profiles, as well as support, locking and finishing element for the closing panel (16).

8. "CONSTRUCTIVE LAY-OUTS APPLIED IN A TELECOMMUNICATIONS CABINET", in accordance with the claim 1, is **characterized by** a structure (3) that can be built with the most diverse combination of profiles (4), while keeping its remaining characteristics.
